Europäisches Patentamt

European Patent Office

Office européen des brevets

(11) Veröffentlichungsnummer: **0 017 088**
**B1**

(12)

# EUROPÄISCHE PATENTSCHRIFT

(45) Veröffentlichungstag der Patentschrift:
18.05.83

(51) Int. Cl.³: **H 03 H 15/02**

(21) Anmeldenummer: **80101447.3**

(22) Anmeldetag: **19.03.80**

(54) **Monolithisch integrierte Filterschaltung.**

(30) Priorität: **30.03.79 DE 2912801**

(43) Veröffentlichungstag der Anmeldung:
**15.10.80 Patentblatt 80/21**

(45) Bekanntmachung des Hinweises auf die Patenterteilung:
**18.05.83 Patentblatt 83/20**

(84) Benannte Vertragsstaaten:
**FR GB IT NL**

(56) Entgegenhaltungen:
**DE-A-2 555 835**
**DE-A-2 608 540**
**DE-A-2 704 318**
**DE-B-2 831 398**
**DE-B-2 836 901**

(73) Patentinhaber: **SIEMENS AKTIENGESELLSCHAFT,
Berlin und München Wittelsbacherplatz 2,
D-8000 München 2 (DE)**

(72) Erfinder: **Kaschte, Walter, Züricher Strasse 112,
D-8000 München 71 (DE)**

Monolithisch integrierte Filterschaltung

Die Erfindung bezieht sich auf eine monolithisch integrierte Filterschaltung nach dem Oberbegriff des Patentanspruchs 1.

Eine derartige Filterschaltung stellt einen Resonator dar, dessen Resonanzverhalten von der Kanallänge des in sich geschlossenen Übertragungskanals, von der Anzahl und Fläche der Verschiebeelektroden und von der Taktfrequenz der Ladungsverschiebeanordnungen abhängig ist. Dabei werden Signale, die innerhalb von bestimmten durch die vorstehend genannten Einflussgrössen gegebenen Frequenzbereichen liegen, nahezu ungedämpft übertragen, während Signale aus anderen Frequenzbereichen weitgehend unterdrückt werden.

Eine bekannte Filterschaltung dieser Art ist in der DE-A-2 555 835 beschrieben. Dabei ist der in sich geschlossene Übertragungskanal der einen Ladungsverschiebeanordnung etwa in der Form eines Kreisringes ausgebildet, an den die Übertragungskanäle der weiteren Ladungsverschiebeanordnungen in radialer Richtung angefügt sind.

In der DE-A-2 704 318 ist eine aus CTD-Leitungen bestehende Leitungsverzweigung dargestellt, bei der die auf einen Verzweigungspunkt zulaufenden und die von ihm weglaufenden Leitungen mit unidirektionalem Übertragungsverhalten jeweils zu Leitungspaaren zusammengefasst sind. Allen Leitungspaaren ist eine Umladekapazität gemeinsam, die als eine MOS-Kapazität mit einem Kapazitätsbelag in Form eines gleichseitigen Dreiecks realisiert ist. Bei dieser Umladekapazität handelt es sich jedoch nicht um einen in sich geschlossenen Übertragungskanal eines integrierten Filters.

In der DE-A-2 608 540 ist eine Filterschaltung, bestehend aus CTD-Leitungen, beschrieben, bei der zur Bildung einer Resonatorschaltung Teile dieser CTD-Leitungen zu resonanzfähigen Leiterschleifen (Kreisringen) zusammengeschaltet sind. In einzelnen Verzweigungspunkten weisen diese Leiterschleifen jeweils Verschiebeelektroden mit einem in Form eines gleichschenkeligen Dreiecks ausgebildeten Ansatzes auf, von dem die abzweigenden CTD-Leitungen ausgehen. Eine Abstufung der radialen Abmessungen der vor und nach einem Verzweigungspunkt liegenden Verschiebeelektroden innerhalb einer solchen Leiterschleife ist jedoch nicht vorgesehen.

Auf einem Halbleiterkörper monolithisch integrierte Ladungsverschiebeanordnungen, die auch als «Charge Transfer Devices» oder als CTD's bezeichnet werden, werden in dem Buch «Charge Transfer Devices» von Séquin und Tompsett, Academic Press Inc., New York, 1975, auf den Seiten 1 bis 18 generell beschrieben. Sie weisen eine Eingangsstufe auf, vgl. die Seiten 48 bis 50 des genannten Buches, in der ein über eine Leitung ankommendes Eingangssignal einer entgegengesetzt zu dem Halbleiterkörper dotierten Zone (Eingangsdiode) oder einem auf einer Begrenzungsfläche des Halbleiterkörpers isoliert angeordneten Eingangsgate zugeführt wird. Gegeneinander phasenverschobene Taktspannungen, die den Verschiebeelektroden und ggf. dem Eingangsgate oder der Eingangsdiode zugeführt werden, bewirken die Umformung des Eingangssignals in eine periodische Folge von Ladungspaketen, die dann im Halbleiterkörper unterhalb der Verschiebeelektroden schrittweise in Übertragungsrichtung fortbewegt werden. Am Ausgang der Ladungsverschiebeanordnung befindet sich im allgemeinen eine Ausgangsstufe, die diese Ladungspakete nacheinander aufnimmt, in elektrische Ausgangssignale umformt und einem ausgangsseitigen Anschluss zuführt. Ausgangsstufen dieser Art sind in dem genannten Buch auf den Seiten 52 bis 58 beschrieben und dargestellt.

Es ist auch bekannt, zwei Ladungsverschiebeanordnungen nebeneinander auf einem Halbleiterkörper anzuordnen und so zu betreiben, dass die in der einen Anordnung verschobenen Ladungspakete aus einem Bereich unterhalb einer vorgegebenen Verschiebeelektrode in einen Bereich unterhalb einer Verschiebeelektrode der zweiten Anordnung transferiert werden und sodann in dieser weiterlaufen. Beispiele hierfür sind dem bereits genannten Buch auf den Seiten 243 bis 244, insbesondere Fig. 7.3, und der DE-PS 2 555 835, zu entnehmen.

Der vorliegenden Erfindung liegt die Aufgabe zugrunde, bei Filterschaltungen der eingangs genannten Art die Übertragungsverluste zu verringern und eine möglichst hohe, obere Grenzfrequenz der zu übertragenden Signale zu gewährleisten. Das wird erfindungsgemäss durch die im kennzeichnenden Teil des Patentanspruchs 1 angeführten Massnahmen erreicht.

Der mit der Erfindung erzielbare Vorteil besteht insbesondere darin, dass durch den im Knotenpunkt gemessene Winkel zwischen der Richtung des angefügten Übertragungskanals und der Übertragungsrichtung des in sich geschlossenen Übertragungskanals sowohl niedrige Übertragungsverluste als auch eine hohe Grenzfrequenz und ein einfaches Design bei der Herstellung der Halbleiterschaltung erreicht werden. Besonders einfache Designlösungen ergeben sich bei einer Weiterbildung der Filterschaltung gemäss den Ansprüchen 3, 4, 5 oder 8. Die in den Ansprüchen 6 und 7 gekennzeichneten Weiterbildungen der Erfindung erlauben die Realisierung auch solcher Filterschaltungen, bei denen die Fläche der dem Knotenpunkt unmittelbar benachbarten Verschiebeelektrode oberhalb des in sich geschlossenen Übertragungskanals wesentlich grösser ist als die Fläche der dem Knotenpunkt unmittelbar benachbarten Verschiebeelektrode oberhalb des angefügten Übertragungskanals.

Die Erfindung wird nachstehend anhand der Zeichnung näher erläutert. Dabei zeigt:

Fig. 1 die Prinzipschaltung eines bekannten integrierten Filters,

Fig. 2 eine erste Ausführungsform einer Teilschaltung eines erfindungsgemässen Filters,

Fig. 3 einen Querschnitt durch die Teilschaltung nach Fig. 2,

Fig. 4 eine zweite Ausführungsform derselben Teilschaltung und

Fig. 5 eine nach der Erfindung ausgebildete Filterschaltung.

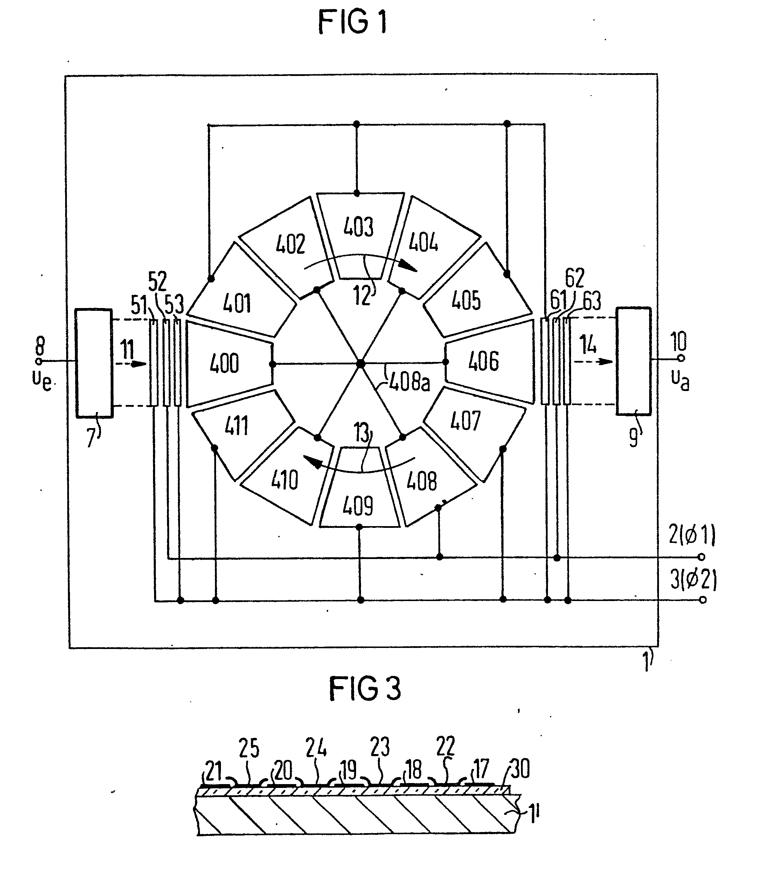

In Fig. 1 ist eine aus der DE-PS 2 555 835 bekannte Filterschaltung dargestellt. Sie ist auf einem dotierten Halbleiterkörper 1 integriert, dessen eine Begrenzungsfläche mit einer elektrisch isolierenden Schicht bedeckt ist. Auf dieser Schicht sind Verschiebeelektroden aus elektrisch leitendem Material aufgebracht, die jeweils mit einem von zwei Anschlüssen 2 oder 3 verbunden sind. Dabei gehören die trapezförmig ausgebildeten, in Form eines Kreisringes nebeneinander angeordneten Elektroden 400 bis 411 zu einer ersten Ladungsverschiebeanordnung mit einem in sich geschlossenen Übertragungskanal, der unterhalb der Elektroden in einer der genannten Begrenzungsfläche benachbarten Zone des Halbleiterkörpers verläuft. Die seitlichen Begrenzungen des Kanals fallen in Fig. 1 mit den äusseren und inneren radialen Begrenzungen der Elektroden 400 bis 411 zusammen. Im Bereich der Elektrode 400 mündet der Übertragungskanal einer zweiten Ladungsverschiebeanordnung, deren Elektroden teilweise dargestellt und mit 51 bis 53 bezeichnet sind, in radialer Richtung in den ringförmigen Kanal ein, während im Bereich der Elektrode 406 der Übertragungskanal einer dritten Ladungsverschiebeanordnung, deren Elektroden teilweise dargestellt und mit 61 bis 63 bezeichnet sind, aus dem ringförmigen Kanal austritt. Die zweite Ladungsverschiebeanordnung ist mit einer Eingangsstufe 7 ausgestattet, der ein Eingangssignal $u_e$ über einen Anschluss 8 zugeführt wird, während die dritte Ladungsverschiebeanordnung mit einer Ausgangsstufe 9 versehen ist, von der ein Ausgangssignal $u_a$ an einen Anschluss 10 abgegeben wird.

Die Elektroden 52, 62, 408 und die mit dieser über die Leitungen 408a verbundenen Elektroden 400, 402, 404, 406 und 410 sind mit dem Anschluss 2 verbunden, die übrigen Elektroden mit dem Anschluss 3. Unter dem Einfluss von zwei gegeneinander phasenverschobenen Spannungen Φ1 und Φ2, die jeweils den Anschlüssen 2 und 3 zugeführt werden, wird das Eingangssignal $u_e$ in der Eingangsstufe 7 in eine Reihe von Ladungspaketen umgeformt, die in der Übertragungsrichtung 11 der zweiten Ladungsverschiebeanordnung fortbewegt werden und schliesslich unter die Elektrode 400 gelangen. Anschliessend werden sie im ringförmigen Kanal in der durch die Pfeile 12 und 13 angegebenen Übertragungsrichtung weiterbewegt und – sofern $u_e$ innerhalb eines vorgegebenen Frequenzbereiches liegt – über den Kanal der dritten Ladungsverschiebeanordnung ausgekoppelt und in Richtung des Pfeiles 14 der Ausgangsstufe 9 zugeführt, in der sie in das Ausgangssignal $u_a$ umgeformt werden.

Die Summe der Flächen der Elektroden 53 und 411 entspricht der Fläche der Elektrode 400. Die Elektroden 401 bis 406 sind der Elektrode 400 flächengleich, die Elektroden 407 bis 410 sind der Elektrode 411 flächengleich. Schliesslich entspricht die Summe der Flächen der Elektroden 407 und 61 der Fläche der Elektrode 406. Die Flächenverhältnisse der Elektroden 411 und 53 und der Elektroden 407 und 61 müssen einem vorgegebenen Wert entsprechen, der das Resonanzverhalten des Filters und damit den zu übertragenden Frequenzbereich mitbestimmt.

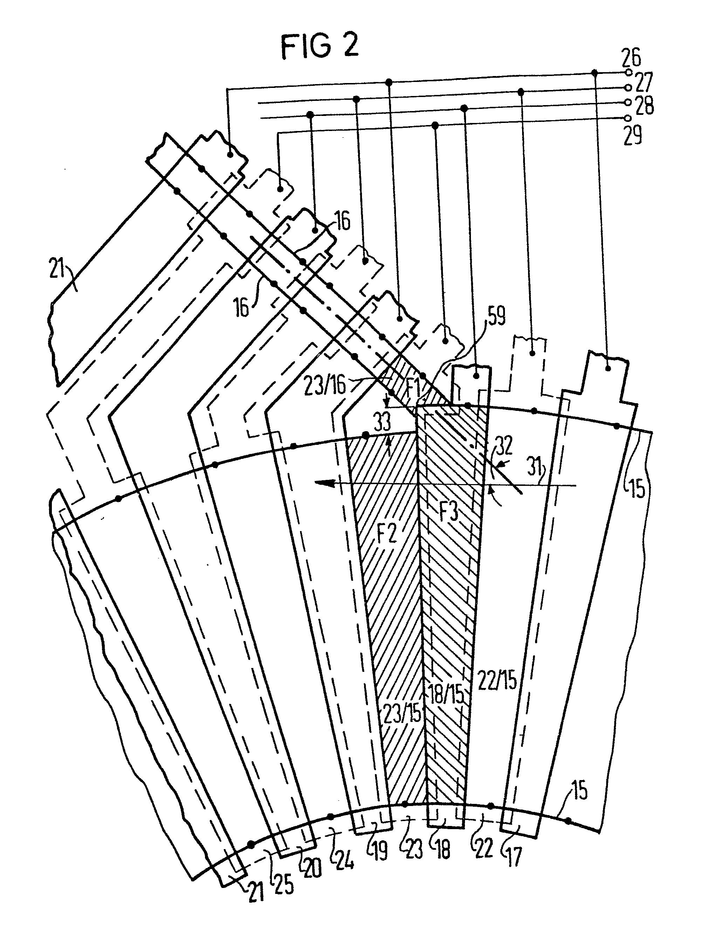

In Fig. 2 ist eine erste erfindungsgemässe Ausführungsform der bei einem monolithisch integrierten Filter vorgesehenen Abzweigung eines CTD-Übertragungskanals aus einem in sich geschlossenen CTD-Übertragungskanal schematisch dargestellt. Diese Abzweigung würde in Fig. 1 etwa der im Bereich der Elektroden 406 und 61 liegenden Teilschaltung entsprechen. Dabei sind die lateralen Begrenzungen der Übertragungskanäle durch mit Punkten versehene Linien 15 und 16 gekennzeichnet. Die Linien 15 stellen Kreisbogenstücke dar und begrenzen einen kreisringförmig ausgebildeten, in sich geschlossenen Übertragungskanal, während der abzweigende Übertragungskanal durch gerade Linien 16 begrenzt ist. Zwischen den Linien 15 und 16 ist die den Halbleiterkörper bedeckende, elektrisch isolierende Schicht als eine Dünnschicht ausgebildet, während sie ausserhalb derselben eine Dickeschicht darstellt. Für den Fall, dass der Halbleiterkörper aus z. B. p-dotiertem Silizium besteht und die Isolierschicht aus $SiO_2$ gebildet ist, bezeichnet man die genannten Dünn- und Dickschichten auch als Gateoxid- und Feldoxidbereiche.

Auf der isolierenden Schicht sind eine Reihe von durch ausgezogene Linien dargestellte leitende Belegungen 17 bis 21 angeordnet, von denen die Belegungen 19 bis 21 oberhalb von beiden Übertragungskanälen 15 und 16 liegen, während die Belegungen 17 und 18 lediglich oberhalb des ringförmigen Kanals 15 angeordnet sind. Zwischen diesen und durch eine isolierende Schicht von ihnen getrennt, befinden sich weitere leitende Belegungen 22 bis 25, die in Fig. 2 durch gestrichelte Linien dargestellt sind. Die Belegungen 17, 19 und 21 sind über Zuleitungen mit einem Anschluss 26 verbunden, der mit einer ersten Taktspannung Φ1′ beschaltet ist. Die Belegungen 22 und 24 liegen an einem Anschluss 27, dem eine zweite Taktspannung Φ2′ zugeführt wird. In gleicher Weise sind die Belegungen 18 und 20 über einen Anschluss 28 mit einer Taktspannung Φ3′ belegt, während die Belegungen 23 und 25 über den Anschluss 29 an eine Taktspannung Φ4′ geführt sind. Diejenigen Teile der Belegungen 17 bis 25, die jeweils oberhalb des Kanals 15 oder des Kanals 16 angeordnet sind, bilden die diesen Kanälen zugeordneten Verschiebeelektroden. Beispielsweise ist in Fig. 2 derjenige Teil der Belegung 23, der oberhalb des Kanals 15 liegt, mit 23/15 bezeichnet und schraffiert, während der oberhalb des Kanals 16 liegende, ebenfalls schraffierte Teil derselben Belegung mit 23/16 bezeichnet ist. Der oberhalb von 15 liegende Teil der Belegung 18 ist mit 18/15 bezeichnet und in anderer Richtung schraffiert.

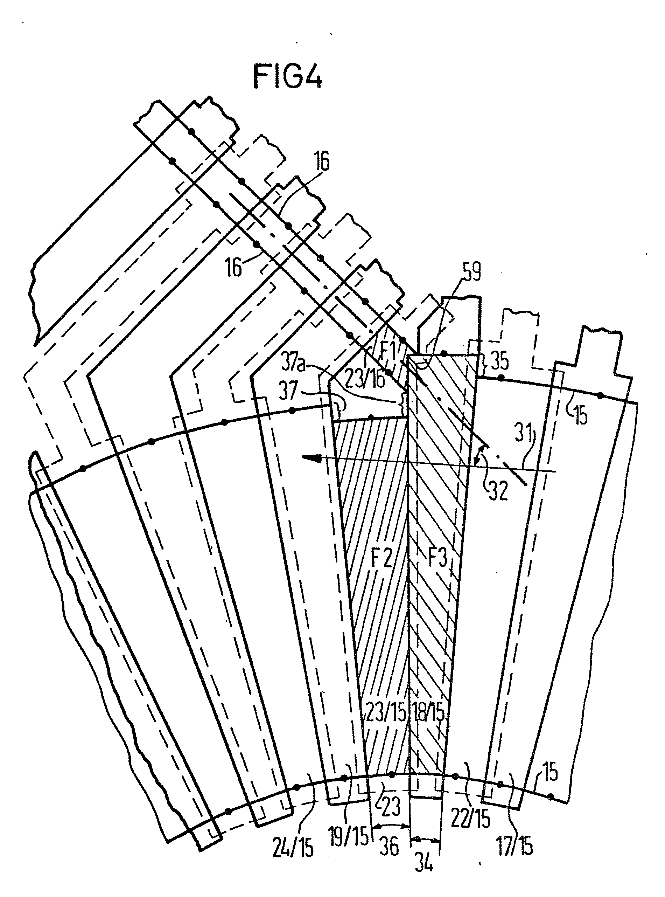

In Fig. 3 ist ein Querschnitt der Anordnung von Fig. 2 gezeigt, der entlang der unteren Linie 15 verläuft. Hieraus ist ersichtlich, dass die Elektroden oberhalb des Halbleiterkörpers 1' in einer Reihe nebeneinanderliegen und gleich breit ausgebildet sind. Lediglich die Randzonen der Belegungen 22 bis 25 überlappen die Randzonen der Belegungen 17 bis 21 geringfügig, damit sich zwischen den einzelnen Verschiebeelektroden möglichst kleine Spalte ergeben. Der unterhalb der Belegungen liegende Gateoxidbereich ist mit 30 bezeichnet. Die Belegungen 17 bis 21 bestehen vorzugsweise aus hochdotiertem, polykristallinen Silizium, während die Belegungen 22 bis 25 entweder aus demselben Material oder aus Aluminium gefertigt sind.

Unter dem Einfluss der Taktspannungen $\Phi1'$ bis $\Phi4'$ werden Ladungspakete im Kanal 15 (Fig. 2) schrittweise von rechts nach links übertragen. Im Bereich der Elektrode 18/15 bzw. im Knotenpunkt der Kanäle 15 und 16 ist die Übertragungsrichtung im Kanal 15 durch den Pfeil 31 angegeben. Der abzweigende Kanal 16 verläuft hierzu in einem Winkel 32, der einerseits wesentlich kleiner ist als 90° und anderseits so gross gewählt ist, dass der Kanal 16 mit seiner ganzen Breite unter der Randzone der Elektrode 18/15 in den Kanal 15 einmündet. Diese Randzone besteht aus einem Kreisbogenstück, das den Kanal 15 in radialer Richtung begrenzt und anderseits aus einem in Fig. 2 mit 33 bezeichneten Stück, das der Differenz zwischen den radialen Abmessungen der Elektroden 18/15 und 23/15 entspricht. Diese Differenz ergibt sich aus der Bedingung, dass die Summe der Flächen F1 und F2 der Elektroden 23/16 und 23/15, die den Kanälen 15 und 16 getrennt zugeordnet sind, der Fläche F3 der Elektrode 18/15, die allein dem ringförmigen bzw. in sich geschlossenen Übertragungskanal zugeordnet ist, entsprechen soll. Aus Fig. 2 lässt sich ableiten, dass eine Verkleinerung des Winkels 32 schliesslich dazu führen muss, dass der Kanal 16 nicht mehr ausschliesslich unterhalb der Randzone der Elektrode 18/15 mit seiner vollen Breite in den Kanal 15 einmündet. Da nämlich zwischen den Begrenzungen der Kanäle 15 und 16 im Bereich des Teils 33 ein technologisch bedingter Mindestabstand bestehen bleiben muss, würde der Kanal 16 in diesem Fall bereits teilweise unterhalb der Elektrode 22/15 abzweigen, was aber die Wirkungsweise der Schaltung stark beeinträchtigen müsste. Würde der Winkel 32 anderseits bei etwa 90° liegen, so wäre die Übertragung von Ladungspaketen aus dem Kanal 15 in den Kanal 16 wesentlich verlustreicher und langsamer als bei der Ausführungsform nach Fig. 2. Für viele Anwendungsfälle kann es beispielsweise vorteilhaft sein, den Winkel 32 zu 45° zu wählen, da hierbei der Schaltungsentwurf von Maschinen ausgeführt werden kann, denen relativ einfache Bestimmungsgrössen für das Design der Kanalabzweigung eingegeben werden.

den. Bei einem Abzweigungswinkel 32 von 45° lässt sich auch das aus dem Frequenzverhalten der Schaltung gegebene Verhältnis F2 zu F1 relativ einfach berechnen.

Auch die in Fig. 1 im Bereich der Elektroden 53 und 400 dargestellte Einmündung eines Übertragungskanals in den in sich geschlossenen Übertragungskanal kann entsprechend Fig. 2 ausgeführt werden. Dabei ist dann in Fig. 2 lediglich die Anschaltung der Taktspannungen insoweit zu ändern als nunmehr die Taktspannungen $\Phi1'$, $\Phi2'$, $\Phi3'$ und $\Phi4'$ jeweils den Anschlüssen 26, 27, 28 und 29 zugeführt werden. Es ergibt sich dann eine Übertragungsrichtung im Kanal 15 von links nach rechts, wobei die im Kanal 16 ebenfalls von links nach rechts bewegten Ladungspakete im Knotenpunkt der Kanäle 15 und 16, d.h. unterhalb der Elektrode 18/15, in den Kanal 15 eintreten.

Fig. 4 zeigt eine andere Ausführungsform der Anfügung eines weiteren Kanals 16 an den in sich geschlossenen Übertragungskanal 15. Die bereits anhand der Fig. 2 beschriebenen Teile sind dabei mit den gleichen Bezugszeichen versehen. Im Unterschied zu Fig. 2 ist die Elektrode 18/15 mit einem kleineren Teilungswinkel 34 ausgeführt. Anderseits ist ihr Aussenradius gegenüber den Elektroden 22/15 und 17/15 um einen Betrag 35 vergrössert, so dass ihre Fläche F3 gegenüber der Fig. 2 unverändert ist. Die Verkleinerung des Teilungswinkels 34 wird durch einen entsprechend vergrösserten Teilungswinkel 36 der Elektrode 23/15 ausgeglichen, die ihrerseits wieder durch eine Verringerung des Aussenradius um das mit 37 bezeichnete Stück in ihrer Fläche F2 gegenüber der Fig. 2 unverändert bleibt. Die Elektroden 19/15, 24/15 usw. sowie 22/15, 17/15 usw. sind von diesen Änderungen nicht betroffen. Gemäss Fig. 4 ergibt sich eine in radialer Richtung verlängerte Randzone der Elektrode 18/15, die es ermöglicht, auch dann den Kanal 16 unter einem Winkel 32 anzufügen, wenn der Unterschied der Aussenradien der Elektroden 22/15 und 19/15 sehr klein ist. Mit dieser Ausführung können also Abzweigungen oder Einmündungen von weiteren Kanälen 16 auch für den Fall vorgenommen werden, dass das Verhältnis der Elektrodenflächen F2 zu F1 wesentlich grösser ist als nach Fig. 2.

Das Design der Schaltung wird im Ein- bzw. Auskopplungsbereich des Kanals 16 mit besonderem Vorteil so gewählt, dass ausgehend vom äusseren Rand der Elektrode 23/15 zunächst ein technologisch bedingter Mindestabstand (37a in Fig. 4) der Kanalgrenzen festgelegt wird und der Kanal 16 dann unter Einhaltung dieses Mindestabstandes mit einem solchen Winkel 32 gegenüber der Übertragungsrichtung 31 angeordnet wird, dass er mit seiner ganzen Breite unterhalb des äusseren Randes der Elektrode 18/15 liegt und der Elektrode 22/15 noch nicht zu nahe kommt. Dabei ist wesentlich, dass die linke äussere Ecke der Elektrode 18/15 (vgl. Fig. 2 und 4) im unmittelbaren Ein- bzw. Auskopplungsbereich des Kanals 16 liegt. Bei einer solchen Ausführung ergibt sich der Vorteil, dass zwischen den Kanälen 15 und 16 unterhalb der Belegung 23 ein die Elektroden 23/ 15 und 23/16 trennender, stegartiger Dickschichtbereich der den Halbleiterkörper 1 bedeckenden Isolierschicht bestehen bleibt, dessen auslaufende Kanten einen rechten und einen stumpfen Winkel aufweisen.

Würde dagegen der Kanal 16 abweichend von den in den Fig. 2 und 4 gezeigten Ausführungen so angeordnet sein, dass er nur unterhalb des etwa in Richtung 31 verlaufenden Randes der Elektrode 18/15 in den Kanal 15 einmündet bzw. von diesem abzweigt und würde weiterhin die linke äussere Ecke der Elektrode 18/15 nicht mehr im unmittelbaren Ein- bzw. Auskopplungsbereich des Kanals 16 liegen, so bliebe ein stegartiger Dickschichtbereich zwischen den Kanälen 15 und 16 bestehen, der in einem spitzen Winkel ausläuft. Dieser wäre aber nur mit grossen technologischen Schwierigkeiten mit der gewünschten Genauigkeit zu realisieren.

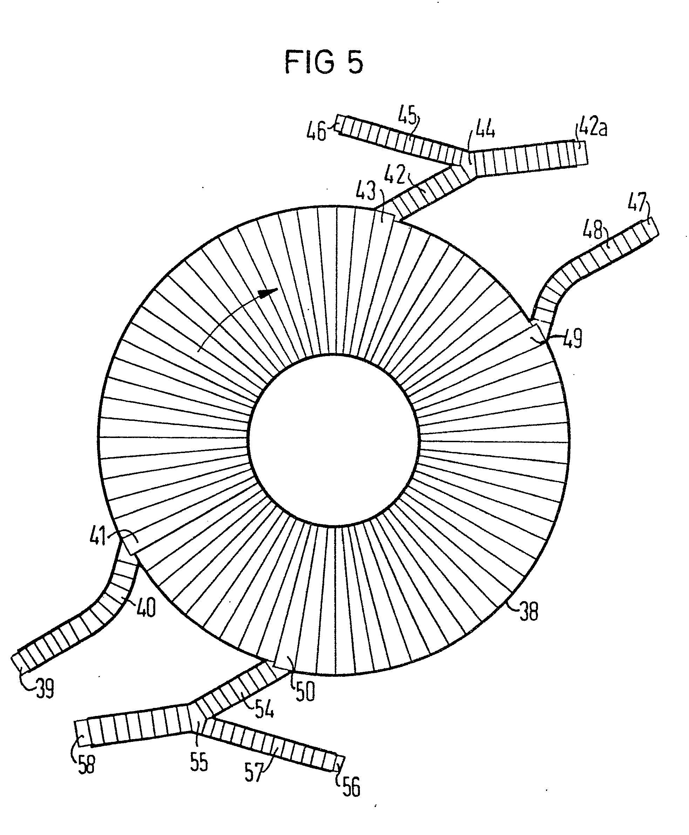

In Fig. 5 ist eine nach der Erfindung ausgebildete, monolithisch integrierte Filterschaltung schematisch dargestellt, bei der der in sich ge-schlossene Übertragungskanal 38 ebenfalls kreis-förmig ausgebildet ist. Die Übertragungsrichtung verläuft dabei im Uhrzeigersinn. Eine mit einer Eingangsstufe 39 versehene Ladungsverschiebeanordnung 40 mündet mit ihrem Kanal unterhalb der Elektrode 41 in den Kanal 38. Eine Ladungsverschiebeanordnung 42 zweigt mit ihrem Kanal unterhalb der Elektrode 43 aus dem Kanal 38 ab. In den Kanal der Anordnung 42 mündet unterhalb der Elektrode 44 der Kanal 45 einer weiteren La-dungsverschiebeanordnung, die mit einer Ein-gangsstufe 46 ausgestattet ist. In der Stufe 46 empfangene Signale werden in Ladungspakete umgeformt, schrittweise im Kanal 45 verschoben und unterhalb der Elektrode 44 zu den über die Anordnung 42 übertragenen, aus dem Kanal 38 ausge-koppelten Ladungspaketen summiert. Die Anord-nung 42 weist eine Ausgangsstufe 42a auf. Über eine mit einer Eingangsstufe 47 ausgestattete Anordnung 48 werden Ladungsmengen unterhalb der Elektrode 49 in den Kanal 38 eingeführt, während unterhalb der Elektrode 50 wieder ein Kanal 54 abzweigt, der sich unterhalb einer Elektrode 55 mit dem Kanal einer eine Eingangsstufe 56 aufweisenden Anordnung 57 vereinigt. Die Ausgangsstufe der zu dem Kanal 54 gehörigen Ladungsverschiebeanordnung ist mit 58 bezeichnet.

Wie aus Fig. 5 ersichtlich ist, können die weiteren Ladungsverschiebeanordnungen 40, 42, 48 und 54, deren Kanäle in den Kanal 38 einmünden oder von ihm abzweigen, einen geradlinigen oder kurvenförmigen Verlauf aufweisen, ohne dass die Funktionsweise der Anordnung hierdurch gestört wird. Darüber hinaus können Anordnungen, die entsprechend Fig. 5 ausgebildet sind, mit gleichartig ausgebildeten Anordnungen auf einem Halb-leitersubstrat oder auf unterschiedlichen Halb-leitersubstraten zusammengeschaltet werden, wobei die Ausgangsstufe 42a mit einer der Stufe 39 entsprechenden Eingangsstufe der nächstfolgenden Anordnung und die Eingangsstufe 47 mit einer der Stufe 58 entsprechenden Ausgangsstufe dieser Anordnung verbunden werden. Anderseits können die Eingangsstufe 39 mit einer der Stufe 42a entsprechenden Ausgangsstufe einer vorhergehenden Anordnung und die Ausgangsstufe 58 mit einer der Stufe 47 entsprechenden Stufe der vorhergehenden Anordnung verbunden sein. Durch eine Abstufung der Übertragungsbandbreiten der einzelnen Filterschaltungen gemäss Fig. 5 gegeneinander, die durch eine entsprechende Bemessung der Flächen der jeweils in sich geschlossenen Übertragungskanäle und insbesondere durch eine Bemessung der Innenradien dieser Kanäle erreicht wird, können auch komplizierte Frequenzcharakteristiken der gesamten Filterschaltung realisiert werden.

Obwohl die CTD-Anordnungen der bisher be-schriebenen, erfindungsgemässen Filterschaltun-gen als CCD-Anordnungen (ladungsgekoppelte Anordnungen) ausgebildet sind, können selbst-verständlich auch andere CTD-Anordnungen an ihre Stelle treten. Beispielsweise können BBD-Anordnungen verwendet werden, die sich von den CCD-Anordnungen im wesentlichen dadurch unterscheiden, dass im Halbleiterkörper unterhalb der einzelnen Verschiebeelektroden angeordnete, gegen dieselben versetzte, entgegengesetzt dotierte Zonen vorgesehen sind. Weiterhin können die CTD-Anordnungen im 2-Phasen, 3-Phasen, 4-Phasen oder Mehrphasenbetrieb arbeiten.

**Patentansprüche**

1. Monolithisch integrierte Filterschaltung, bei der auf einem Körper aus dotiertem Halbleitermaterial (1') eine Ladungsverschiebeanordnung (CTD) mit einem in sich geschlossenen Übertragungskanal (15) vorgesehen ist, an den in vor-gegebenen Knotenpunkten die Übertragungs-kanäle (16) weiterer Ladungsverschiebeanord-nungen (CTD) angefügt sind, die einerseits mit dem Eingang und anderseits mit dem Ausgang der Filterschaltung verbunden sind, bei der die Ladungsverschiebeanordnungen isoliert über einer Begrenzungsfläche des Körpers angeordnete, mit Taktspannungen ($\Phi 1$–$\Phi 4$) beaufschlagte Ver-schiebeelektroden (17–25) aufweisen und bei der die einem Knotenpunkt unmittelbar benachbarten Verschiebeelektroden (23/15, 23/16), die mit ein und derselben Taktspannung beaufschlagt sind, aber zwei Übertragungskanälen (15, 16) getrennt zugeordnet sind, ein vorgegebenes Flächenverhältnis zueinander aufweisen und mit der Summe ihrer Flächen (F1 + F2) der Fläche (F3) der ihnen benachbarten Verschiebeelektrode (18/15) gleich sind, die dem in sich geschlossenen Übertragungskanal (15) allein zugeordnet ist, wobei die dem in sich geschlossenen Übertragungskanal (15) zugeordneten Verschiebeelektroden (22/15, 18/15), die in Übertragungsrichtung (31) vor und im Knotenpunkt liegen, gegenüber den in Übertragungsrichtung (31) hinter dem Knotenpunkt liegenden (23/15) in ihren äusseren radialen Abmessungen abgestuft ausgebildet sind, dadurch gekennzeichnet, dass der weitere Übertragungskanal (16) zu der Übertragungsrichtung (31) des in sich geschlossenen Übertragungskanals (15) im Knotenpunkt unter einem Winkel (32) verläuft, der wesentlich kleiner ist als 90°, jedoch noch so gross ist, dass der weitere Übertragungskanal (16) mit seiner ganzen Breite im Bereich des äusseren Randes der Verschiebeelektrode (18/15) angeordnet ist, die dem in sich geschlossenen Übertragungskanal (15) allein zugeordnet ist.

2. Filterschaltung nach Anspruch 1, dadurch gekennzeichnet, dass die Ladungsverschiebeanordnungen als ladungsgekoppelte Vorrichtungen (CCD) ausgebildet sind.

3. Filterschaltung nach einem der Ansprüche 1 oder 2, dadurch gekennzeichnet, dass der in sich geschlossene Übertragungskanal (15) als Kreisring ausgebildet ist.

4. Filterschaltung nach Anspruch 3, dadurch gekennzeichnet, dass die seitlichen Begrenzungen der Verschiebeelektroden (17/15 bis 25/15) der Ladungsverschiebeanordnung mit dem in sich geschlossenen Übertragungskanal (15) in radialer Richtung des Kreisrings verlaufen.

5. Filterschaltung nach einem der vorhergehenden Ansprüche, dadurch gekennzeichnet, dass der Winkel (32) zwischen dem angefügten, weiteren Übertragungskanal (16) und der Übertragungsrichtung (31) im Knotenpunkt des in sich geschlossenen Übertragungskanals (15) 45° beträgt.

6. Filterschaltung nach einem der vorhergehenden Ansprüche, dadurch gekennzeichnet, dass die im Bereich eines Knotenpunktes liegende Verschiebeelektrode (18/15), die lediglich der Ladungsverschiebeanordnung mit dem in sich geschlossenen Übertragungskanal (15) zugeordnet ist, bei konstanter Elektrodenfläche (F3) mit verringerten Abmessungen (34) in der Übertragungsrichtung (31) und mit vergrösserten Abmessungen (35) in senkrechter Richtung hierzu ausgebildet ist.

7. Filterschaltung nach Anspruch 6, dadurch gekennzeichnet, dass die dem Knotenpunkt unmittelbar benachbarte Verschiebeelektrode (23/15), die lediglich zu der Ladungsverschiebeanordnung mit dem in sich geschlossenen Übertragungskanal (15) gehört, bei konstanter Elektrodenfläche (F2) mit vergrösserten Abmessungen (36) in der Übertragungsrichtung (31) und mit verkleinerten Abmessungen (37) in senkrechter Richtung hierzu ausgebildet ist.

8. Filterschaltung nach einem der vorhergehenden Ansprüche, dadurch gekennzeichnet, dass der unmittelbare Ein- bzw. Auskopplungsbereich des weiteren Übertragungskanals (16) die äussere Ecke (59) der im Knotenpunkt liegenden, dem in sich geschlossenen Übertragungskanal (15) allein zugeordneten Elektrode (18/15), die von der in Umfangsrichtung des in sich geschlossenen Übertragungskanals (15) verlaufenden Randzone und von der in radialer Richtung dieses Kanals (15) verlaufenden äusseren Randzone gebildet ist, wenigstens randseitig umfasst.

**Claims**

1. A monolithic integrated filter circuit, in which on a body consisting of doped semiconductor material (1′), there is arranged a charge transfer device (CTD) having a transmission channel (15) which is closed on itself and to which are connected at predetermined junction points, the transmission channels (16) of further charge transfer devices (CTD), which, on the one hand, are connected to the input and, on the other hand, to the output of the filter circuit; in which the charge transfer devices have shift electrodes (17–25) which are fed with clock pulse voltages ($\Phi 1$–$\Phi 4$) and arranged in insulated manner above a boundary surface of the body; and in which the shift electrodes (23/15), 23/16 which are directly adjacent to a junction point and are supplied with the same clock pulse voltage, but are separately assigned to two transmission channels (15, 16), have a predeterminded ratio of surface area, one to the other and with the sum of their surface areas (F1 + F2) equal to the surface area (F3) of the shift electrode (18/15) which is adjacent thereto and which is separately assigned to the closed transmission channel (15), wherein the shift electrodes (22/15), 18/15, which are assigned to the closed transmission channel (15) and which, in the direction of transmission (31), lie before and in the junction point, are so designed as to be stepped as regards their outer radial dimensions in comparison with those electrodes (23/15) which lie behind the junction point in the direction of transmission (31), characterised in that the further transmission channel (16) runs at an angle (32) to the direction of transmission (31) of the closed transmission channel (15) at the junction point, which angle is essentially less than 90° but is still so large that, the further transmission channel (16) over its whole width is arranged in the region of the outer edge of the shift electrode (18/15) which is assigned to the closed transmission channel (15) alone.

2. A filter circuit according to Claim 1, characterised in that the charge transfer devices are formed as charge-coupled devices (CCD).

3. A filter circuit according to one of Claims 1 or 2, characterised in that the closed transmission channel (15) is in the form of an annulus.

4. A filter circuit according to Claim 3, characterised in that the lateral boundaries of the shift electrodes (17/15 to 25/15) of the charge transfer device having the closed transmission channel (15), run in radial directions of the annulus.

5. A filter circuit according to one of the preceding Claims, characterised in that the angle (32) between the connected further transmission channel (16) and the transmission direction (31) is 45° at the junction point of the closed transmission channel (15).

6. A filter circuit according to one of the preceding Claims, characterised in that the shift electrode (18/15), which lies in the region of a junction point and which is assigned only to the charge transfer device having the closed transmission channel (15), is designed to have reduced dimensions (34) in the transmission direction (31) and increased dimensions (35) in the direction at right angles thereto, with a constant electrode surface area (F3).

7. A filter circuit according to Claim 6, characterised in that the shift electrode (23/15), which is directly adjacent to the junction point and is only assigned to the charge transfer device having the closed transmission channel (15) is designed to have increased dimensions (36) in the transmission direction (31) and decreased dimensions (37) in the direction at right angles thereto, with a constant electrode surface area (F2).

8. A filter circuit according to one of the preceding Claims, characterised in that the direct input or output coupling region of the further transmission channel (16) surrounds, at least at the edge side, the outer corner (59) of the electrode (18/15) which lies at the junction point and is assigned to the closed transmission channel (15) only, which corner is formed by the edge zone running in the circumferential direction of the closed transmission channel (15) and by the outer edge zone running in the radial direction of said channel (15).

**Revendications**

1. Filtre intégré monolithiquement, dans lequel sur un corps en matériau semi-conducteur dopé (1') est prévu un dispositif à transfert de charge (CTD) comportant un canal de transmission (15) fermé sur lui-même, auquel sont raccordés, en des points de jonction prédéterminés, les canaux de transmission (16) d'autres dispositifs à transfert de charge (CTD), qui sont couplés d'une part à l'entrée et d'autre part à la sortie du filtre, dans lequel les dispositifs à transfert de charge comportent des électrodes de transfert (17–25) disposés de façon isolée au-dessus d'une surface de délimitation du corps et recevant des tensions de cadences ($\Phi$1–$\Phi$4), et dans lequel les électrodes de transfert (23/15), 23/16) directement voisines d'un point de jonction, qui reçoivent une seule et même tension de cadence mais sont associées de façon distincte à deux canaux de transmission (15, 16), présentent un rapport de surface prédéterminé et la somme de leur surface (F1 + F2) est égale à la surface (F3) de l'électrode de transfert voisine qui est associée seule au canal de transmission (15) fermé sur lui-même, les dimensions radiales extérieures des électrodes de transfert (22/15, 18/15) qui sont associées au canal de transmission (15) fermé sur lui-même et qui se trouvent avant et au niveau du point de jonction dans la direction de transmission (31) étant étagées par rapport à celles des électrodes (23/15) qui se trouvent derrière le point de jonction dans la direction de transmission (31), caractérisé par le fait qu'au point de jonction l'autre canal de transmission (16) forme par rapport à la direction de transmission (31) du canal de transmission (15) fermé sur lui-même, un angle qui est nettement plus faible que 90° mais qui est cependant suffisamment important pour que toute la largeur de l'autre canal de transmission (16) soit disposée dans la région du bord extérieur de l'électrode de transfert (18/15) qui est associée seule au canal de transmission. (15) fermé sur lui-même.

2. Filtre suivant la revendication 1, caractérisé par le fait que les dispositifs à transfert de charge se présentent sous la forme de dispositifs à couplage direct de charge (CCD).

3. Filtre suivant l'une des revendications 1 ou 2, caractérisé par le fait que le canal de transmission (15) fermé sur lui-même se présente sous la forme d'un anneau circulaire.

4. Filtre suivant la revendication 3, caractérisé par le fait que les délimitations latérales des électrodes de transfert (17/15) à 25/15) du dispositif à transfert de charge comportant le canal de transmission (15) fermé sur lui-même s'étendent suivant la direction radiale de l'anneau circulaire.

5. Filtre suivant l'une des revendications précédentes, caractérisé par le fait que l'angle (32) entre l'autre canal de transmission (16) raccordé et la direction de transmission (31) au niveau du point de jonction du canal de transmission (15) fermé sur lui-même est égal à 45°.

6. Filtre suivant l'une des revendications précédentes, caractérisé par le fait que dans le cas d'une surface (F3) d'électrode constante, l'électrode de transfert (18/15) qui se trouve dans la région d'un point de jonction et qui est associée simplement au dispositif à transfert de charge comportant le canal de transmission (15) fermé sur lui-même, est réalisée avec des dimensions plus faibles (34) dans la direction de transmission (31) et avec des dimensions plus importantes (35) dans la direction perpendiculaire.

7. Filtre suivant la revendication 6, caractérisé par le fait que dans le cas d'une surface (E) d'électrode constante, l'électrode de transfert (23/15) qui est située au voisinage immédiat du point de jonction et qui appartient uniquement au dispositif à transfert de charge comportant le canal de transmission (15) fermé sur lui-même, est réalisée avec des dimensions plus importantes (36) dans la direction de transmission (31) et avec des dimensions plus faibles (37) dans la direction perpendiculaire.

8. Filtre suivant l'une des revendications précédentes, caractérisé par le fait que la région d'entrée ou de sortie directe de l'autre canal de transmission (16) entoure au moins sur le bord les coins extérieurs (59) de l'électrode (18/15) qui se trouve au niveau du point de jonction et qui est associée seule au canal de transmission (15) fermé sur lui-même, et qui est formée par la zone marginale s'étendant dans la direction périphérique du canal de transmission (15) fermé sur lui-même et par la zone marginale extérieure s'étendant suivant la direction radiale de ce canal (15).

## FIG 1

## FIG 3

FIG 2

FIG4

# FIG 5